Europäisches Patentamt

European Patent Office

Office européen des brevets

(11) Veröffentlichungsnummer: **0 220 541**
**B1**

(12) **EUROPÄISCHE PATENTSCHRIFT**

(45) Veröffentlichungstag der Patentschrift:
09.08.89

(51) Int. Cl.⁴: **C23C 18/18, C23C 18/34,**
**C23C 18/40, B23K 35/40,**
**H05K 3/00**

(21) Anmeldenummer: 86113722.2

(22) Anmeldetag: 03.10.86

(54) Verfahren zum Metallisieren von transparenten Leiterbahnen.

(30) Priorität: 16.10.85 DE 3536821

(43) Veröffentlichungstag der Anmeldung:
06.05.87 Patentblatt 87/19

(45) Bekanntmachung des Hinweises auf die Patenterteilung:
09.08.89 Patentblatt 89/32

(84) Benannte Vertragsstaaten:
AT DE FR GB IT NL SE

(56) Entgegenhaltungen:
EP-A- 0 132 784

(73) Patentinhaber: Nokia Graetz Gesellschaft mit
beschränkter Haftung.
Östliche-Karl-Friedrich-Strasse 132,
D-7530 Pforzheim(DE)

(72) Erfinder: Zondler, Rolf, Dr., Marabustrasse 26,
D-7000 Stuttgart 50(DE)

ACTORUM AG

## Beschreibung

Die Erfindung bezieht sich auf ein Verfahren zum Metallisieren von transparenten Leiterbahnen aus Indium/Zinnoxid auf Substraten gemäß dem Oberbegriff des Anspruchs 1.

Aus der DE-PS 28 07 350 ist eine Flüssigkristall-Anzeigevorrichtung bekannt, die ein Glassubstrat als Träger für die Anzeïgevorrichtung und für einen integrierten Schaltkreis (IC-Chip) aufweist. Auf dem Glassubtrat sind transparente Leiterbahnen aus Indiumoxid vorhanden. Die Metallisierung dieser Leiterbahnen im nicht sichtbaren Bereich der Anzeigevorrichtung erfolgt derart, daß zwei chromhaltige Zwischenschichten aufgebracht werden, um darauf eine Goldauflage aufzubringen. Auf dem IC-Chip ist dann noch eine Kontaktierungsschicht aus fünf Schichten vorgesehen, die aus Chrom, Kupfer, Gold, Kupfer bzw. Blei/Zinn bestehen. Die Metallisierung der Leiterbahnen bzw. das Aufbringen der Schichten erfolgt durch Aufdampf- bzw. Aufsprühverfahren. Diese Verfahren erfordern einen hohen energetischen und technischen Aufwand.

Der Erfindung liegt die Aufgabe zugrunde, ein einfacheres Verfahren zum Metallisieren von transparenten Leiterbahnen aus Indium/Zinnoxid auf Substraten der eingangs genannten Art anzugeben.

Die Lösung dieser Aufgabe erfolgt durch, eine Vorbehandlung der Leiterbahnen gemäß Anspruch 1 bevor darauf stromlos eine lötbare Metallschicht abgeschieden wird. Vorteilhafte Ausgestaltungen der Erfindung sind in den Unteransprüchen 2 bis 3 enthalten.

Die Erfindung wird nun beispielsweise anhand von Figuren näher erläutert. Es zeigen:

Fig. 1 eine Draufsicht auf eine Anzeigevorrichtung und
Fig. 2 das teilweise Eintauchen der Anzeigevorrichtung in ein Bad.

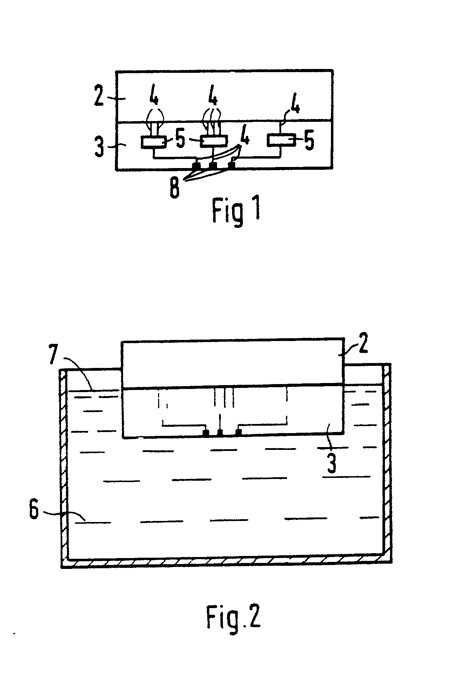

Die in Fig. 1 dargestellte Anzeigevorrichtung 1 weist einen Anzeigebereich 2 und einen im späteren, eingebauten Zustand der Anzeigevorrichtung nicht sichtbaren Bereich 3 auf. Der Anzeigebereich besteht beispielsweise aus einer Flüssigkristallanzeige (nicht dargestellt), die auf einem Substrat, beispielsweise aus Glas, aufgebaut ist. Dieses Substrat ist auch im Bereich 3 vorhanden und trägt dort Leiterbahnen 4, die zu Bauelementen 5, beispielsweise integrierten Schaltungen, und Anschlüssen 8 der Anzeigevorrichtung 1 führen. Die Anschlüsse der Bauelemente 5 sind mit den Leiterbahnen 4 durch Löten oder durch Kleben mit einem Leitkleber verbunden. Für diese Verbindung der Bauelemente 5 mit den Leiterbahnen 4 ist es notwendig, daß die Leiterbahnen eine entsprechende Metallisierung aufweisen.

Die im Anzeigebereich 2 der Anzeigevorrichtung 1 vorhandenen Elektroden bestehen aus einer transparenten, elektrisch leitenden Schicht aus einem Oxid einer Indium-Zinn-Legierung. Die Leiterbahnen 4 im Bereich 3 bestehen aus dem gleichen Material, da dann die Herstellung der Elektroden im Anzeigebereich 2 und der Leiterbahnen 4 im Bereich 3 gleichzeitig erfolgen kann. Da aber Leiterbahnen aus Indium/Zinnoxid keine lötfähige Oberfläche aufweisen, sind sie zu metallisieren.

Der Anzeigebereich 2 der Anzeigevorrichtung 1 wird gefertigt und geprüft. Die einwandfreien Anzeigevorrichtungen weisen in diesem Zustand im Bereich 3 noch keine Bauelemente 5 auf. Zum Metallisieren der Leiterbahnen 4 kommt die Anzeigevorrichtung in eine Bearbeitungsstation in der auf den Leiterbahnen 4 stromlos eine lötbare Metallschicht abgeschieden wird. Die Metallschicht kann aus Gold, Silber, Nickel, Kupfer oder Zinn bestehen. Das Abscheiden der Metallschicht geschieht durch Eintauchen des Bereiches 3 in ein Bad aus dem entsprechenden Metallsalz und Zusätzen zur Stabilisierung des Bades, wie beispielsweise Komplexbildnern, Reduktionsmitteln und Puffersubstanzen. Typische Badzusammensetzungen für eine Abscheidung von Gold sind folgende:

| 0,6 g/l $AuCl_3$ | oder | 1 g/l $AuCl_3$ |
|---|---|---|
| 1 g/l $Na_2HPO_4$ | | 30 g/l Trinatriumcitrat |
| 1 g/l NaHO | | 11 ml HCL 37% |
| 3 g/l $Na2SO_4$ | | |
| 10 g/l KCN | | |

In Fig. 2 ist das Eintauchen der Anzeigevorrichtung 1 in ein schematisch dargestelltes Bad 6 gezeigt. Die Anzeigevorrichtung wird gerade so weit eingetaucht, daß die Badoberfläche 7 mit der Grenzlinie zwischen dem Anzeigebereich 2 und dem Bereich 3 zusammenfällt. Vorzugsweise soll auf die aus einem Oxid einer Indium-Zinn-Legierung bestehenden Leiterbahnen 4 eine Schicht aus Gold abgeschieden, deren Dicke im Bereich von 50 bis 1000 nm liegen soll. Zur besseren Haftung erfolgt vor dem Metallisieren der Leiterbahnen eine Reduktion des Oxids der Indium-Zinn-Legierung zu Indium-Zinn. Diese Reduktion der Oberfläche des Oxids der Indium-Zinn-Legierung kann in einem Bad aus Natriumhydrogenphosphit oder Natriumborhydrid oder Aminoboran oder Formaldehyd oder Hydrazin erfolgen.

Sollte die Haftung des abgeschiedenen Goldes auf den Indium-Zinn-Leiterbahnen 4 nicht ausreichen, so kann das Auftragen einer Haftschicht auf die Leiterbahnen vorgesehen werden. Dazu wird Nickel,

EP 0 220 541 B1

Chrom oder Kupfer stromlos auf die Leiterbahnen 4 abgeschieden. Auch diese Abscheidung kann durch Tauchen in einem Bad erfolgen, welches für die Abscheidung von beispielsweise Nickel folgende Zusammensetzung aufweist:

| | Phosphorhaltige Bäder | | Borhaltige Bäder |
|---|---|---|---|
| Ni-Ionen: | $NiCl_2$ | | $NiCl_2$ |
| | $NiSO_4$ | | $NiSO_4$ |
| Reduktionsmittel: | $NaH_2PO_2$ | | Natriumboranat |
| | (Na-Hyphophosphit) | | N-Diäthylborazan |
| | | | N-Dimethylborazan |
| organische Komplexbildner: | Hydroxiessigsäure | | Äthylendiamin |
| | Hydroxipropionsäure | | Natriumcitrat |
| | Zitronensäure | | Natriumsuccinat |
| | Malonsäure | | Natriumacetat |
| Beschleuniger: | Anionen der Succin-, Adipinsäure | | |
| | Alkalifluoride | | |
| Stabilisatoren: | Thioharnstoff | | Thalliumsulfat |
| | Bleisulfid | | |
| | Zinnsulfid | | |
| Puffer: | wie Komplexbildner | | wie Komplexbildner |
| pH-Rgulierer: | $H_2SO_4$ | | Na OH |
| | HCL | | |
| | $Na_2CO_3$ | | |
| | NaOH | | |
| | $NH_4OH$ | | |
| Netzmittel: | Alkoholsulfate | | |
| | Fettsäuresulfonate | | |
| | Arylalkylsulfonate | | |

Eine typische Badzusammensetzung für das Abscheiden von Nickel ist folgende:
30 g/l $NiCl_2 \times 6\,H_2O$
10 g/l $NaH_2PO_2$
100 g/l Natriumcitrat
50 g/l $NH_4CL$
pH 8-10
Nach dem Reduzieren und Abscheiden einer Haftschicht aus Nickel erfolgt dann die oben beschriebene Metallisierung.

Nach dem Metallisieren werden die Bauelemente 5 auf den Bereich 3 aufgebracht und ihre Anschlüsse durch Löten oder Kleben mit den Leiterbahnen 4 verbunden, so daß eine mit den Bauelementen zu einer Baueinheit verbundene Anzeigevorrichtung entsteht.

**Patentansprüche**

1. Verfahren zur Herstellung einer stromlos abgeschiedenen, lötbaren Metallschicht auf transparenten Leiterbahnen aus einem Oxid einer Indium-Zinn-Legierung auf dem bei fertigen Anzeigevorrichtungen nicht sichtbaren Teil eines Substrates, **dadurch gekennzeichnet**, daß die Oberfläche der Leiterbahnen (4) vor dem stromlosen Abscheiden der Metallschicht zu Indium-Zinn-Legierung reduziert wird.

2. Verfahren nach Anspruch 1, dadurch gekennzeichnet, daß die Reduzierung durch Tauchen des Substrates in ein Bad aus Natriumhydrogenphosphit, Natriumborhydrid, Aminoboran, Formaldehyd oder Hydrazin erfolgt.

3. Verfahren nach Anspruch 1, dadurch gekennzeichnet, daß auf den Leiterbahnen (4) zuerst eine Haftschicht aus Nickel, Chrom oder Kupfer stromlos abgeschieden wird.

**Claims**

1. Process for the production by means of currentless deposition of a solderable metal film on transparent conductor strips of indium or zinc oxide on the nonvisible part of the substrate of finished indicator devices, characterized in that the surface of the conductors strips (4) is reduced to indium or zinc before the currentless deposition of the metal film.

2. Process according to Claim 1, characterized in that the reduction is obtained by dipping the substrate in a bath of sodium biphosphite, sodium hydroboron, aminoborane, formaldehyde, or hydrazine.

3. Process according to Claim 1, characterized in that an adhesion layer of nickel, chromium or copper is first formed by means of currentless deposition on the conductor strips (4).

**Revendications**

1. Procédé pour la fabrication d'une couche métallique précipitée sans courant, soudable, sur des pistes conductives transparentes en oxyde d'indium et stannique sur la partie d'un substrat non visible sur des dispositifs d'affichage finis, caractérisé en ce que la surface des pistes conductives (4) est réduite en indium/étain avant la précipitation sans courant de la couche métallique.

2. Procédé selon la revendication 1, caractérisé en ce que la réduction est réalisée par immersion du substrat dans un bain composé de biphosphite de sodium, d'hydrure de bore sodé, d'amino-borane, d'aldéhyde formique ou d'hydrazine.

3. Procédé selon la revendication 1, caractérisé en ce qu'une couche d'adhérence en nickel, chrome ou cuivre est d'abord précipitée sans courant sur les pistes conductives (4).

Fig 1

Fig.2